# EUROPEAN PATENT APPLICATION

(11) **EP 1 099 776 A1**
(43) Date of publication of application: **16.05.2001**
(21) Application number: 00309958.7
(22) Date of filing: 09.11.2000
(51) Int. Cl.: C23C 14/02, H01L 21/306, H01L 21/336, H01L 21/285, H01L 21/3205

(54) **Plasma cleaning step in a salicide process**

(30) Priority: 09.11.1999 US 437573
(71) Applicant: Applied Materials, Inc., Santa Clara, California 95054 (US)
(72) Inventor: Saigal, Dinesh, San Jose, CA 95135 (US); King, Rochelle, Redwood City, CA 94065 (US); Singhal, Ajay, Santa Clara, CA 95051 (US)
(74) Representative: Allard, Susan Joyce

(57) **Abstract**

Prior to forming a silicide in the gate and drain/source regions of a MOS device, the exposed silicon regions to be coated and reacted with a metal are subjected to a reactive plasma cleaning process. The plasma gas is preferably comprises hydrogen or comprises a hydrogen/helium mixture or a fluorocarbon/helium mixture such as NF₃/helium, CF₄/helium, SF₆/helium, etc.

## Description

The present invention generally relates to an improved salicide process. More specifically, the invention relates to a reactive plasma cleaning process performed on a metal/silicon interface in a salicide process.

One process for constructing integrated circuits uses self-aligned silicide (salicide) technology to form contacts for metal oxide semiconductors (MOS). A conventional salicide process involves the steps of depositing a metal film over a MOS structure under processing conditions which result in the reaction of the metal with exposed silicon areas of a source/drain region and polysilicon in a gate to form silicide contacts.

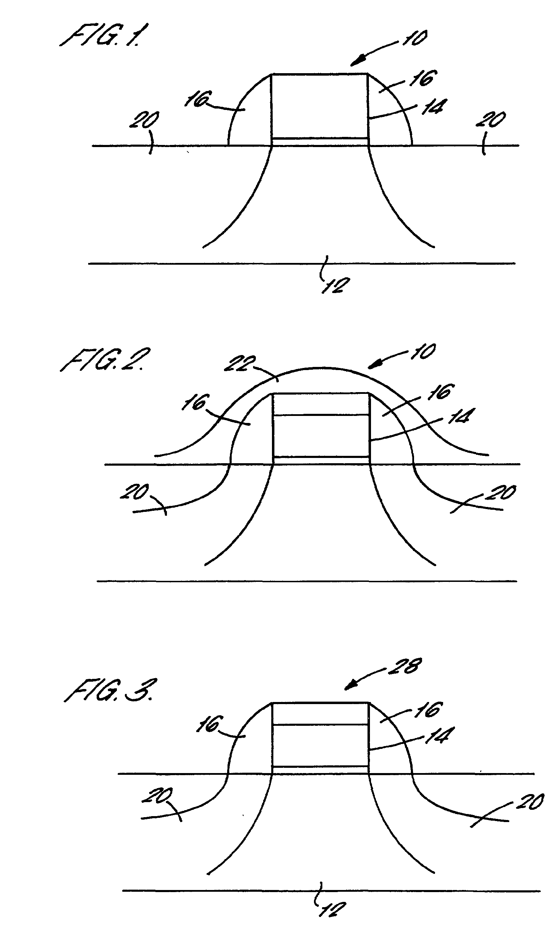

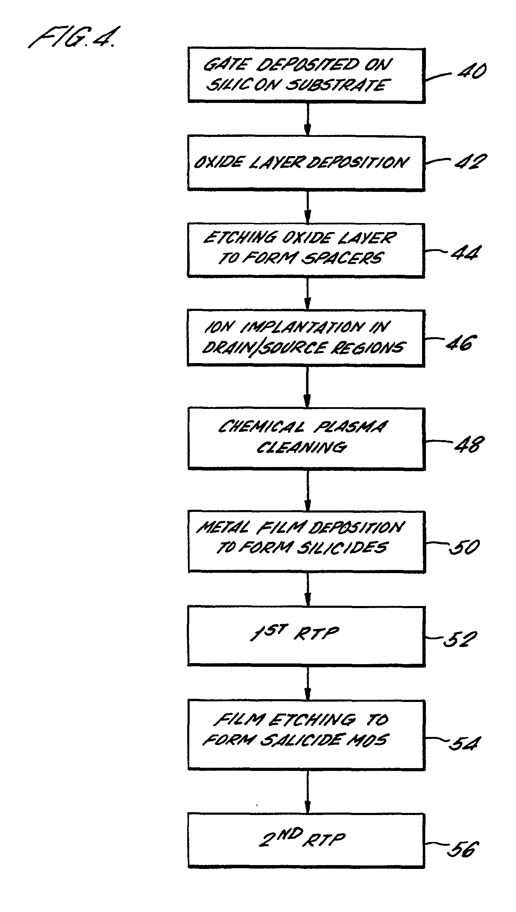

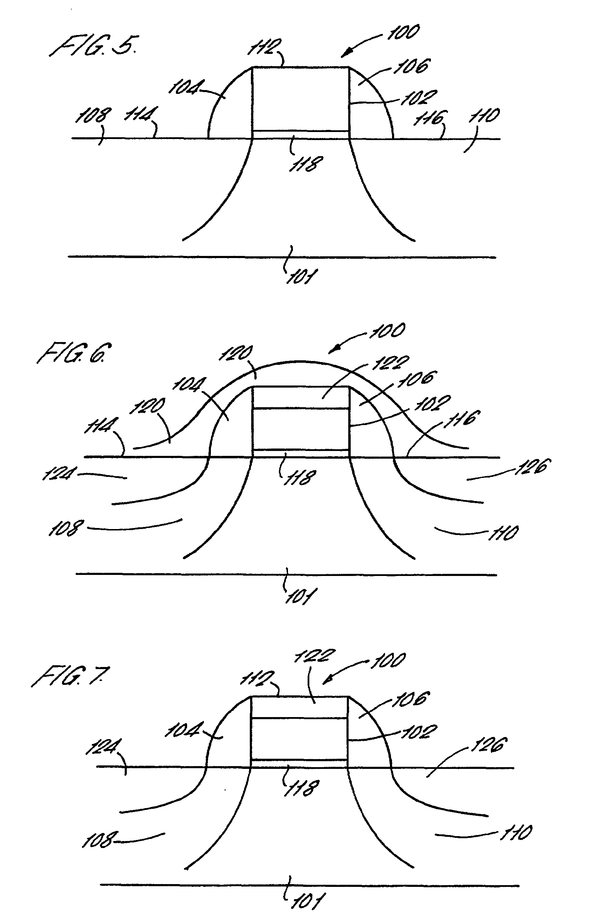

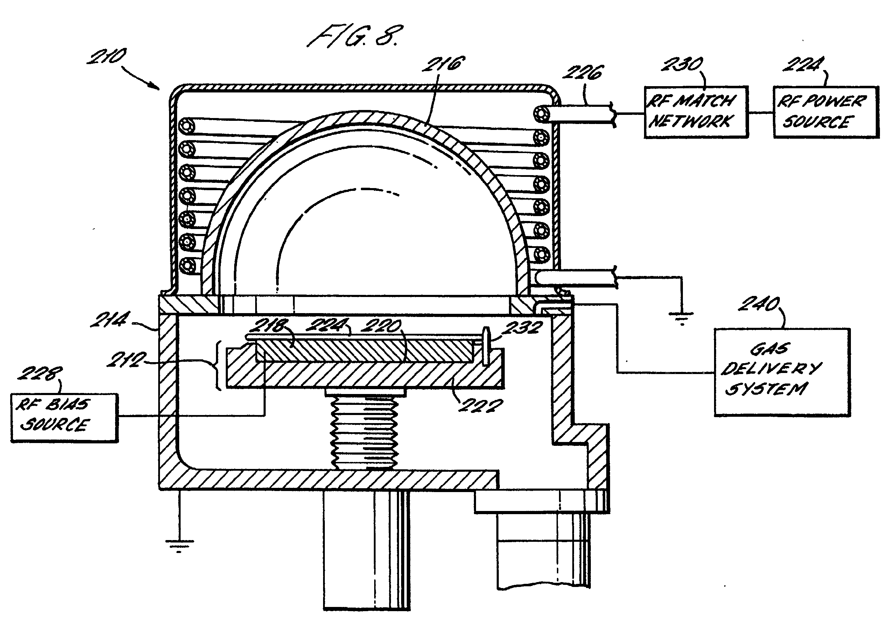

In a conventional salicide process, a polysilicon gate (shown in Figure 4) is formed on the substrate prior to the silicide formation. An oxide layer, such as a SiO₂ layer, is deposited over the polysilicon gate by chemical vapor deposition and then anisotropically etched to form insulating sidewall spacers flanking the polysilicon gate. Figure 1 shows a MOS structure 10 formed on a substrate 12 following the etch step. The structure 10 generally includes an exposed gate 14 flanked by spacers 16 and silicon source/drain areas 20.

Following the etching step, regions of the gate 14 and silicon source/drain 20 are left exposed. As shown in Figure 2, a reactive metal 22 is deposited on the structure 10 by chemical vapor deposition or physical vapor deposition. A first rapid thermal process (RTP) causes the metal to react with the exposed silicon regions and form silicides that exist initially as a high resistivity phase silicide. The unreacted metal is then etched away leaving the salicided structure 28 shown in Figure 3. A second RTP forms the desired low resistivity phase of the silicide.

The salicide process is dependent on the cleanliness of the metal/silicon interface. A thin layer of native oxides can interfere with the salicide formation by preventing intimate contact between the metal film and underlying silicon.

Conventionally, the silicon interface has been cleaned by performing a wet clean of the exposed silicon prior to the deposition of the metal thereover. The wet clean is effective at removing the oxides on the silicon surface including the thicker oxides involved with implant/activation in the source/drain regions. However, the post dip rinse/dry process, as well as the delays experienced prior to loading the substrate in the deposition system, causes the regrowth of some native oxide. This oxide may not be a serious problem if an oxygen gettering metal film such as Ti is used as the silicide-forming material. However, the film of choice for sub 0.25µm MOSFETS are noble materials such as Co or Ni wherein reduction of this oxide is difficult.

Another method used to rid the silicon surface of the oxide is to perform an in-situ argon plasma sputter clean just prior to the metal film deposition. There are, however, several problems with this approach. First, the argon sputter clean is a physical process and therefore results in removal of both oxide and underlying silicon because some over etch is required to insure that all oxides have been removed. This loss of silicon is not desirable in ultra shallow junction devices due to the generation of excessive leakage currents. Secondly, the argon ion bombardment can cause damage to the source/drain areas which could result in increased contact resistance. Thirdly, the sputtered silicon from a salicided structure (which can be about 50% exposed silicon) coats the quartz dome of the sputter etch chamber. Over time, this build-up can cause ignition problems in the chamber due to difficulties with plasma coupling. Thus, there is a need for a simple and effective method of cleaning semiconductor structures preparatory to depositing a metal film thereon.

The method of the present invention is particularly adapted to the salicide process wherein a metal film is reacted with exposed silicon surfaces to form silicides. The process generally involves contacting the exposed silicon surfaces of the structure with a plasma of hydrogen to chemically react with the oxide and other reactant contaminants and remove them from the exposed surfaces. The plasma may, in addition to hydrogen, include helium and trace amounts of argon. In other embodiments, the plasma may be a mixture of helium and fluorocarbons such as NF₃, CF₄, SF₆, etc. Preferably, the deposition of the metal onto the silicon to form the silicide preferably follows immediately after the plasma cleaning within the vacuum environment to minimize or completely avoid formation of native oxides. The use of hydrogen, with or without helium, avoids (a) damage to the source/drain areas and (b) damage to the sputter etch chamber.

The following drawings are provided by way of example.

Figure 1 is a schematic partial section view of a MOS structure.

Figure 2 is a view similar to Fig. 1 illustrating the structure with the metal film deposited thereon.

Figure 3 is a schematic view of the completed salicided MOS structure.

Figure 4 is a flow chart illustrating the sequential steps of the salicide process.

Figure 5 is a schematic partial section view of the condition of the structure at an intermediate step (prior to metal film deposition) of the salicide process.

Figure 6 is a view similar to Fig. 5 illustrating the structure with the metal film deposited thereon.

Figure 7 is a schematic view of the completed salicided MOS structure.

Figure 8 is a cross sectional view of a typical pre-clean chamber useful for the present invention.

The method of the present invention represents an improvement for the salicide process. The sequential steps of the salicide process, including the plasma cleaning step according to the present invention, are shown in the flow chart of Figure 4. As illustrated, the salicide process involves the sequential steps of:
(a) pattern forming polysilicon onto a substrate (step 40);
(b) depositing a dielectric oxide layer over the gate area (step 42);
(c) etching the dielectric to form spacers (step 44);
(d) ion implantation to dope source/drain area (step 46);
(e) chemical plasma treatment (step 48);
(f) metal film deposition (step 50);
(g) a first rapid thermal process (step 52);
(h) selectively etching the metal film (step 54); and
(i) a second RTP process (step 56).
The salicide process will be described generally, followed by a detailed description of the cleaning method of the present invention.

With reference to Figure 4, the initial step 40 in the salicide process is pattern forming the polysilicon (polycrystalline silicon) onto the silicon substrate. The polysilicon gate preferably is separated from the silicon substrate such as by a thin layer of a silicon oxide. Next, as depicted in step 42 of Figure 4, a dielectric oxide layer such as SiO₂ is deposited by chemical vapor deposition over the gate area and flanking substrate regions (source/drain regions).

In step 44, the oxide layer is etched down leaving an exposed polysilicon surface and flanking silicon areas of the substrate separated by spacers. The condition of the structure at this stage of the process is schematically illustrated in Figure 5, and described in more detail below.

The ion implantation step 46 forms the source/drain regions. This can be done by arsenic (As) or boron (B) ion implantation followed by a source/drain activation anneal step.

A chemical plasma treatment step 48 then cleans the surfaces of the structure formed in the previous step in preparation for metal deposition. The plasma reacts with native oxides and other reactive contaminants formed on the structure to remove them from the affected surfaces.

The metal film deposition step 50 is preferably carried out by sputtering. The condition of the device after step 50 is schematically illustrated in Figure 6. The metal is selected to react with the silicon to form the silicides (*i.e.,* metal silicons) in the gate and source/drain regions. The term "silicon" as used herein means both the monocrystalline and polycrystalline forms of silicon. Reaction of the metal with the silicon is facilitated by subjecting the structure 100 to a first rapid thermal process (RTP), shown as step 52. The RTP causes the metal to form a high resistivity crystalline phase. Because the metal only reacts with portions of the structure 100, the unreacted metal must be etched away at step 54. Finally, in step 56, a second RTP is performed to produce a low resistivity crystalline phase of the silicide. The device may then be glass passivated and contacts may be made.

The plasma cleaning (step 48) begins after the device 100 has been processed to the condition depicted in Figure 5. As illustrated, substrate 101 has deposited thereon a polysilicon gate 102 (step 40) flanked by SiO₂ spacers 104 and 106 (step 44). Regions 108 and 110 have been ion implanted (step 46) and serve as the source/drain regions. As noted above with reference to step 44 of the flow chart, the etching away of the silicon oxide layer leaves silicon oxide spacers 104 and 106 and exposes silicon areas 112,114, and 116. The spacers 104 and 106 prevent the gate 102 and source/drain regions from being electrically short circuited. Note also that the thin dielectric silicon oxide region 118 below the gate 102 also separates the gate 102 from the substrate 101.

The device 100 shown in Figure 5 is then subjected to the plasma cleaning step. This may be carried out in a variety of plasma chambers. Figure 8 is a cross sectional view of a typical pre-clean chamber useful for the present invention. An example of a pre-clean chamber useful for the present invention is the Pre-Clean II Chamber available from Applied Materials, Inc., Santa Clara, California. Generally, the pre-clean chamber 210 has a substrate support member 212 disposed in a chamber enclosure 214 under a quartz dome 216. The substrate support member 212 typically includes a central pedestal plate 218 disposed within a recess 220 on an insulator plate 222, typically constructed of quartz, ceramic or the like. During processing, the substrate 224 is placed on the central pedestal plate 218 and contained thereon by locating pin 232. Preferably, an RF coil 226 is disposed outside of the quartz dome 216 and connected to an RF power source 224 to strike and maintain a plasma of the process gases within the chamber. Generally, a RF match network 230 is provided to match the RF power source 224 and the RF coil 226. Typically, the substrate support member 212 is connected to an RF bias source 228 that provides a bias to the substrate support member 212. The RF power source 224 preferably provides up to about 500W of 2 MHz RF power to the coil 226 and the RF bias source 228 preferably provides up to about 500W of 13.56 MHz RF bias to the substrate support member 212. A gas delivery system 240 is fluidly coupled to the pre-clean chamber 210 to provide the plasma gas(es) to the chamber during processing.

In one embodiment, the MOS device of Figure 5 is placed in the pre-cleaning chamber 210 which is maintained at a pressure between about 30 mtorr and about 80 mtorr. The processing gas comprised of hydrogen or a hydrogen/helium mix, is introduced into the processing region. The processing gas can comprise from about 2% to about 15% hydrogen and from about 85% to about 98% helium, and preferably about 5% hydrogen and about 95% helium by volume. A plasma of the hydrogen or hydrogen/helium gas is struck in the processing region to subject the substrate to a reactive hydrogen plasma environment. The hydrogen plasma is generated by applying between about 50 W and about 500 W of power to the coil 226 from the RF power source 224 and between about 5 W and about 300 W of RF bias power from the RF power source 228 to the substrate support member 212 on which the substrate is disposed. The hydrogen plasma is maintained for between about 10 seconds and about 300 seconds to provide sufficient time for the hydrogen to react with the reactive components of the structure 100, thereby cleaning the structure 100. The hydrogen plasma is preferably generated by applying about 450W RF power to the coil 226 and about 10W RF power to the substrate support member 212, and preferably is maintained for about 60 seconds. Once the pre-cleaning process is completed, the pre-clean chamber 210 is evacuated to exhaust the processing gas and the reacted byproducts.

In another embodiment, the processing gases may include a flourocarbon such as CF₄, SF₆, NF₃, etc. In one example a mixture of helium and NF₃ is used. Helium is flowed into the chamber at a rate of about 45 sccm and NF₃ is flowed at a rate of about 5 sccm. Helium can comprise between about 85% and 95% by volume of the processing gas and NF₃ comprises between about 5% and 15% by volume of the processing gas. Preferably, helium comprises about 90% by volume of the processing gas and NF₃ comprises about 10% by volume of the processing gas. The chamber 210 is maintained at a pressure of about 50m Torr and a coil power of about 100 W and a bias power of about 100 W are applied to the coil 226 and the substrate support member 212, respectively. The NF₃ provides fluorine radicals and ions which have been found to provide reactive cleaning of the silicon and silicon containing surfaces.

The processing gas may also include traces of argon, *i.e.,* preferably not more than about 10% by volume of the plasma gas. The argon gas provides some physical sputtering of the surfaces to be cleaned. It has been learned that some physical cleaning may also be beneficial in combination with the reactive cleaning.

Once the substrate has been cleaned in the cleaning chamber, a thin metal film is formed over the device (step 50) as illustrated in Figure 6. The metal film layer 120 covers the exposed silicon areas 112 (shown in Figure 5), 114, and 116 and reacts with the silicon to form the silicide during the first RTP (step 52), illustrated by regions 122, 124, and 126 of Figure 6. The metals are preferably noble, near noble, or refractory metals, which include Ti, Pt, Pd, Ni, Co, Ta, Mo, and W. The most preferred metals are Ni and Co. As one example, Co reacts with Si to form a low resistivity CoSi₂ phase.

The metal sputtering step may be carried out in a sputtering chamber such as a PVD chamber available from Applied Materials, Inc. The metal deposition step (step 50) is preferably carried out immediately following the cleaning step (step 48) without breaking vacuum by using an integrated processing system such as an Endura® Platform from Applied Materials, Inc. having both a cleaning chamber and a deposition chamber mounted thereon. This configuration allows substrates to be transferred between the cleaning chamber and the deposition chamber under vacuum conditions, thereby minimizing the formation of native oxides on the cleaned surfaces prior to deposition of the metal in the reactive silicide process. Following the metal deposition and reaction step to form the silicide, the device is selectively etched (step 54) to remove the unreacted metal, leaving the salicided device shown in Figure 7. Step 54 is preferably a wet etch using a solution of hydrogen sulfate (H₂SO₄), hydrogen peroxide (H₂O₂)and water.

While the foregoing is directed to the preferred embodiment of the present invention, other and further embodiments of the invention may be devised without departing from the basic scope thereof. The scope of the invention is determined by the claims which follow.

## Claims

1. A salicide (self-aligned silicide) method for manufacturing a metal oxide semiconductor (MOS) of the type in which a metal film is deposited on exposed silicon areas separated by a dielectric material to react therewith to form a silicide, the method comprising, prior to depositing the metal film, cleaning the silicon areas with a plasma comprising at least one of hydrogen and/or a fluorocarbon.

2. The method of claim 1, wherein the silicon areas are exposed surfaces of ion impregnated silicon.

3. The method of claim 1 or claim 2, wherein the metal film is applied by sputtering.

4. The method of any one of claims 1 to 3, wherein the dielectric is or comprises silicon dioxide.

5. The method of any one of claims 1 to 4, wherein the plasma comprises hydrogen, helium, and trace amounts of argon.

6. A method of manufacturing a salicided metal oxide semiconductor, the method comprising:
(a) depositing a polysilicon contact on a silicon substrate separated therefrom by a silicon dioxide layer;
(b) depositing a silicon dioxide layer over the polysilicon contact and flanking portions of the substrate;
(c) selectively etching away the silicon dioxide to expose a top surface of the polysilicon contact flanking portions of the substrate, leaving spacers on the sides of and underneath the polysilicon contact;
(d) impregnating flanking portions of the silicon with ions to form a source or drain regions;
(e) cleaning the exposed silicon and polysilicon surfaces with a plasma comprising at least one of hydrogen and/or a fluorocarbon;
(f) depositing a layer of metal over the contact, spacers and exposed impregnated regions of the substrate to react with the silicon or polysilicon to form a metal silicide; and
(g) etching away the unreacted metal film.

7. The method of claim 6, wherein the steps (e) and (f) are carried out in a substantially oxygen-free vacuum environment.

8. The method of any one of claims 1 to 7, wherein the metal film is selected from the group comprising one or more of noble, near noble, and refractory metals.

9. The method of any one of claims 1 to 7, wherein the metal film is selected from the group comprising one or more of Ti, Pt, Pd, Ni, Ta, Mo, W, and Co.

10. The method of any one of claims 1 to 7, wherein the metal film is a noble metal.

11. The method of any one of claims 1 to 7, wherein the metal film is selected from the group comprising one or both of Ni and Co.

12. The method of any one of claims 6 to 11, wherein the plasma is applied in a sputtering chamber.

13. The method of any one of claims 1 to 12, wherein the fluorocarbon is selected from the group comprising one or more of NF₃, CF₄, and SF₆

14. The method of any one of claims 1 to 4 and 6 to 13, wherein the plasma further comprises helium.

15. The method of claim 14, wherein the plasma comprises a fluorocarbon and helium.

16. The method of claim 15, wherein the volume ratio of the fluorocarbon to helium ranges from between about 0.053 to about 0.176.

17. The method of claims 14, wherein the plasma comprises hydrogen and helium.

18. The method of claim 17, wherein the volume ratio of hydrogen to helium ranges from about 0.022 to about 0.176.

19. The method of any one of claims 1 to 4 and 6 to 18, wherein the plasma further includes trace amounts of argon.
